(19) Europäisches Patentamt
European Patent Office
Office européen des brevets

(11) **EP 0 929 148 A1**

(12) **DEMANDE DE BREVET EUROPEEN**

(43) Date de publication:
**14.07.1999 Bulletin 1999/28**

(51) Int. Cl.$^{6}$: **H03F 1/32**

(21) Numéro de dépôt: **98403344.9**

(22) Date de dépôt: **31.12.1998**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **06.01.1998 FR 9800041**

(71) Demandeur: **ALCATEL**
**75008 Paris (FR)**

(72) Inventeurs:
- **Gourgue, Frédéric**
**75017 Paris (FR)**
- **Soula, Véronique**
**75015 Paris (FR)**

(74) Mandataire: **El Manouni, Josiane**
**COMPAGNIE FINANCIERE ALCATEL**
**Dépt. Propr. Industrielle,**
**30, avenue Kléber**
**75116 Paris (FR)**

(54) **Procédé et système de linéarisation numérique d'un amplificateur**

(57) L'invention concerne un procédé de linéarisation numérique d'un amplificateur présentant une non-linéarité, du type comprenant : une phase préalable (1) de détermination de paramètres de correction de ladite non-linéarité et une phase (2) d'amplification linéaire par prédistorsion (21) puis amplification (22).

Selon l'invention, ladite phase (1) de détermination des paramètres de correction comprend les étapes suivantes : acquisition (11) dudit signal test amplifié, sous forme d'échantillons en bande de base ; définition (12) d'un amplificateur modélisé, par calcul de paramètres d'un modèle prédéterminé d'amplificateur à partir desdits échantillons du signal test amplifié ; calcul (13) desdits paramètres de correction à partir dudit amplificateur modélisé, de façon que ceux-ci permettent de linéariser ledit amplificateur modélisé.

L'invention concerne également un système correspondant de linéarisation numérique d'un amplificateur.

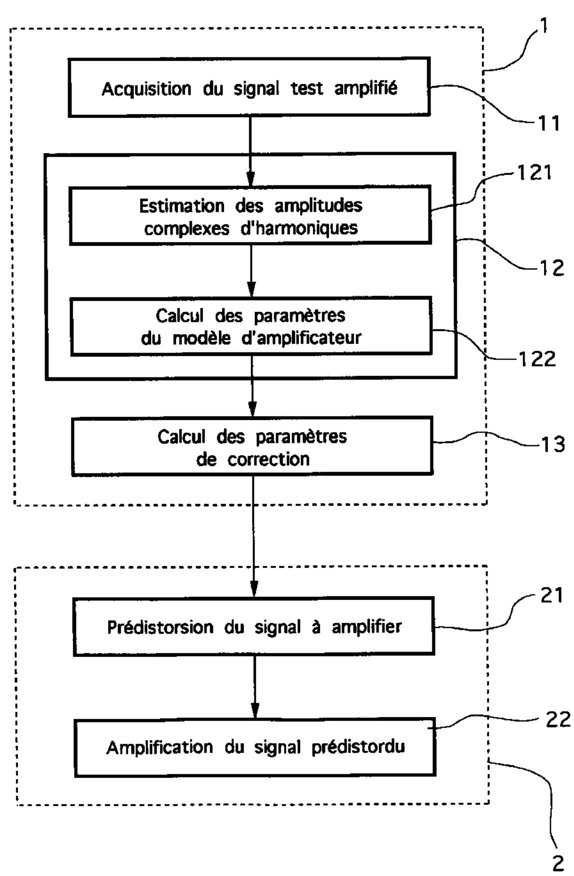


Fig. 3

EP 0 929 148 A1

## Description

Le domaine de l'invention est celui des amplificateurs.

Plus précisément, l'invention concerne un procédé et un système de linéarisation d'un amplificateur.

L'invention s'applique notamment, mais non exclusivement, à la linéarisation des amplificateurs utilisés dans les systèmes de radiocommunication cellulaire (tels que notamment les systèmes GSM 900 (pour "Global System for Mobile" en anglais ou "Groupe spécial Systèmes Mobiles publics de radiocommunication fonctionnant dans la bande des 900 Mhz"), DCS 1800 (pour "Digital Cellular System 1800 Mhz" en anglais), PCS (pour "Personal Communication System" en anglais), IS95, UMTS (Universal Mobile Telephone System), IMT-2000 (International Mobile Telecommunications), CDMA-One, etc.

En effet, les terminaux mobiles comprennent généralement un amplificateur dans leurs chaînes d'émission.

Il est fréquent que l'on souhaite obtenir une amplification linéaire. Un amplificateur n'étant jamais parfaitement linéaire, il convient donc de mettre en oeuvre une linéarisation de l'amplificateur.

Dans le cas des systèmes de radiocommunication, la non-linéarité de l'amplificateur présent dans la chaîne d'émission radio est gênante car elle distord le signal transmis, ce qui se traduit par une dégradation du spectre de ce signal et donc une génération de signaux parasites dans les canaux adjacents au canal utile. En d'autres termes, la non-linéarité de l'amplificateur provoque une augmentation du niveau des émissions parasites dans les canaux adjacents. Ceci conduit au non respect de spécifications visant à limiter les interférences. Ce non respect des spécifications est encore plus accentué lorsqu'une modulation à enveloppe non constante, plus sensible aux défauts de non-linéarité, est utilisée en amont de l' amplificateur. On comprend donc la nécessité d'effectuer une linéarisation de l'amplificateur.

On connaît, dans l'état de la technique, plusieurs solutions pour effectuer une telle linéarisation.

Une première solution connue de linéarisation consiste à utiliser l'amplificateur très en deçà de ses capacités, de façon à travailler dans une zone linéaire. En effet, la non-linéarité de l'amplificateur se manifeste d'autant moins que le niveau de puissance est faible. Cette première solution connue présente l'inconvénient majeur de dégrader le rendement de l'amplificateur. Ainsi, si cet amplificateur est compris dans un terminal mobile, il en diminue l'autonomie.

Une seconde solution connue de linéarisation consiste à utiliser une boucle de correction analogique à rétroaction, ou "feedback" en anglais (cf. fig. 1). Or, cette boucle de correction rajoute des composants analogiques, qui, d'une part, présentent des défauts influant sur les performances du système complet ainsi défini, et d'autre part, subissent une dérive dans le temps rendant la correction de moins en moins effective.

Une troisième solution connue de linéarisation consiste à utiliser une boucle de correction analogique à action directe, ou "Feedforward" en anglais (cf. fig. 2). L'inconvénient d'une telle boucle de correction est qu'elle nécessite un second amplificateur qui doit être très linéaire.

Une quatrième solution connue de linéarisation est décrite dans le document de brevet EP 522 706 A2. Il s'agit d'un procédé de linéarisation comprenant une phase préalable de test et une une phase d'amplification. Lors de la phase préalable de test, on effectue successivement : une amplification d'un signal test ; un échantillonnage du signal de sortie correspondant à faible vitesse sur une durée longue ; une transformation de Fourier des échantillons du signal test amplifié ; un calcul des amplitudes des harmoniques permettant une reconstitution du signal de sortie ; une comparaison du signal d'entrée avec le signal de sortie de l'amplificateur reconstitué, de façon à déterminer des paramètres de distorsion propres à l'amplificateur ; une construction d'une table de paramètres de prédistorsion tels que ceux-ci annulent les paramètres de distorsion propres à l'amplificateur. Lors de la phase d'amplification, on applique au signal à amplifier les paramètres de prédistorsion, de façon que le signal amplifié présent en sortie de l'amplificateur ne soit pas distordu.

En d'autres termes, dans cette quatrième solution, on utilise le principe de la prédistorsion, qui consiste à compenser la non-linéarité de l'amplificateur en rajoutant à l'entrée de celui-ci un bloc présentant une non-linéarité inverse, de façon que la juxtaposition des deux blocs non-linéaires ait une fonction de transfert linéaire. La phase de test, qui consiste dans cette quatrième solution à comparer le signal test d'entrée avec le signal de sortie correspondant, permet précisément de déterminer la distorsion (ou non-linéarité) due à l'amplificateur.

Cette quatrième solution connue est peu avantageuse car elle nécessite beaucoup d'échantillons en sortie de l'amplificateur, et par conséquent une grande quantité de calculs, une place mémoire conséquente ainsi que d'importants temps d'acquisition (c'est-à-dire de récupération) et de traitement des échantillons en sortie de l'amplificateur. En outre, les résultats obtenus sont peu précis. Il est à noter qu'un temps d'acquisition important peut être contradictoire avec certaines contraintes opérationnelles ne laissant que peu de temps pour l'acquisition : signaux non stationnaires ou limite de temps pour l'émission de signaux de test).

En résumé, il apparaît que toutes les solutions connue précitées, visant à permettre la linérarisation d'un amplificateur, présentent des inconvénients, à savoir notamment leurs coûts élevés eu égard à la performance obtenue.

La présente invention a notamment pour objectif de pallier ces différents inconvénients de l'état de la technique.

Plus précisément, l'un des objectifs de la présente invention est de fournir un procédé et un système de linéarisation numérique d'un amplificateur, nécessitant une puissance de calcul plus faible que les solutions connues précitées.

Un objectif complémentaire est de fournir un tel procédé et un tel système ne nécessitant qu'un faible espace mémoire.

Un autre objectif de l'invention est de fournir un tel procédé et un tel système permettant de réduire le temps de saisie des échantillons, en sortie de l'amplificateur, par rapport aux solutions connues de l'état de la technique.

Un autre objectif de l'invention est de fournir un tel procédé et un tel système permettant de réduire le temps de traitement des échantillons de sortie par rapport aux solutions connues de l'état de la technique.

Un objectif supplémentaire de l'invention est de fournir un tel procédé et un tel système permettant d'obtenir des résultats très précis.

Un autre objectif de l'invention est de fournir un tel procédé et un tel système présentant de faibles coûts.

Ces différents objectifs, ainsi que d'autres qui apparaîtront par la suite, sont atteints selon l'invention à l'aide d'un procédé de linéarisation numérique d'un amplificateur présentant une non-linéarité, du type comprenant :

- une phase préalable de détermination de paramètres de correction de ladite non-linéarité, en fonction d'un signal test amplifié présent en sortie dudit amplificateur lorsqu'un signal test est appliqué en entrée ;
- une phase d'amplification linéaire, comprenant les étapes suivantes :
    * prédistorsion, en fonction desdits paramètres de correction, d'un signal d'entrée destiné à être amplifié par ledit amplificateur, de façon à obtenir un signal prédistordu ;
    * amplification dudit signal prédistordu par ledit amplificateur, de façon que le signal prédistordu amplifié présent en sortie dudit amplificateur corresponde audit signal d'entrée amplifié de façon linéaire ;

caractérisé en ce que ladite phase de détermination des paramètres de correction comprend les étapes suivantes :

- acquisition dudit signal test amplifié, sous forme d'échantillons en bande de base ;
- définition d'un amplificateur modélisé, par calcul de paramètres d'un modèle prédéterminé d'amplificateur à partir desdits échantillons du signal test amplifié:
- calcul desdits paramètres de correction à partir dudit amplificateur modélisé, de façon que ceux-ci permettent de linéariser ledit amplificateur modélisé.

La présente invention concerne donc une nouvelle façon de déterminer la loi de prédistorsion (c'est-à-dire les paramètres de correction) à appliquer en amont de l'amplificateur, pour obtenir au final une amplification linéaire.

Plus précisément, le principe général de l'invention consiste à modéliser l'amplificateur réel, puis à calculer la loi de prédistorsion à partir de l' amplificateur modélisé (et non pas à partir de l'amplificateur réel) pour compenser sa non-linéarité.

En d'autres termes, on travaille sur une modélisation de l'amplificateur, et non pas, comme dans le document de brevet EP 522 706 A2 discuté ci-dessus, sur une simple comparaison du signal test d'entrée avec le signal de sortie correspondant (c'est-à-dire avec le signal test amplifié). Il est important de noter que le fait d'utiliser un amplificateur modélisé permet d'obtenir une meilleure précision sur les paramètres de correction à appliquer au signal d'entrée, et donc une meilleure linéarisation de l'amplificateur. D'une façon générale, plus l'amplificateur modélisé est proche de l'amplificateur réel, meilleure est la linéarisation obtenue.

On rappelle que dans le cas de l'application à un terminal mobile, le procédé de linéarisation de l'invention permet de limiter les interférences inter-canaux. Il est clair cependant que l'application du procédé de l'invention n'est aucunement limitée au cas où l'amplificateur est intégré dans un terminal mobile, mais peut être envisagée quelle que soit l'utilisation de cet amplificateur.

De façon avantageuse, ladite étape de définition de l'amplificateur modélisé comprend les étapes suivantes :

- estimation, par analyse spectrale desdits échantillons du signal test amplifié, des amplitudes complexes d'un nombre prédéterminé d'harmoniques à des fréquences connues, lesdites harmoniques étant générées par ladite non-linéarité de l'amplificateur ;
- calcul desdits paramètres du modèle prédéterminé d'amplificateur, par identification d'une part desdites amplitudes complexes estimées et d'autre part d'expressions mathématiques correspondant à des amplitudes complexes d'harmoniques auxdites fréquences connues pour un signal présent en sortie dudit amplificateur modélisé, lesdites expressions mathématiques étant calculées à partir dudit modèle prédéterminé d'amplificateur en supposant que ledit signal test lui est appliqué en entrée.

L'estimation des amplitudes complexes de certaines harmoniques d' intermodulation permet de caractériser

les non-linéarités amplitude-amplitude (AM-AM) et amplitude-phase (AM-PM) de l'amplificateur.

Par ailleurs, du fait que l'on se limite à un nombre prédéterminé d'harmoniques dont on connaît les fréquences, la durée d'acquisition des échantillons du signal test arnplifié peut être réduite.

Préférentiellement, ladite analyse spectrale des échantillons du signal test amplifié appartient au groupe comprenant :

- les analyses spectrales paramétriques ;
- les analyses spectrales par échantillonnage suivi d'une transformée de Fourier.

On notera qu'une analyse spectrale paramétrique offre l'avantage de nécessiter moins de calculs, moins de place mémoire et demande un temps de saisie des échantillons moins long. De plus, il est possible de simplifier énormément ce type d'analyse dans la mesure où l'on connaît d'une part la forme du signal (superposition de plusieurs sinusoïdes) et d'autre part les fréquences des raies (ou harmoniques) dont on veut déterminer les amplitudes.

Dans un mode de réalisation préférentiel de l'invention, ladite étape d'estimation des amplitudes complexes d'harmoniques consiste à calculer : $H^{\sim} = M\,S$, avec :

- $H^{\sim} = [H_1^{\sim}\ H_2^{\sim} \ldots H_p^{\sim}]^T$, un vecteur des amplitudes complexes de p harmoniques considérées ;
- $S = [s_0\ s_1 \ldots S_N]T$, un vecteur de N échantillons du signal test amplifié ;
- M étant une matrice (p,N) prédéterminée.

De cette façon, le calcul du vecteur $H^{\sim}$ est très rapide. En effet, la matrice M, qui ne dépend que des fréquences des harmoniques que l'on cherche à caractériser, est parfaitement connue et peut être calculée une fois pour toutes et stockée en mémoire. N est aussi appelé fenêtre d'échantillonnage.

Avantageusement, ladite matrice M s'écrit :

$$M = ([Z^H Z]^{-1} Z^H), \text{ avec:}$$

- $Z^H$ la transposée Hermitienne de Z ;
- $z_i = \exp(2j\pi f_i)$, $f_i$ étant la fréquence de la ième harmonique considérée ;
- 

$$Z = \begin{bmatrix} 1 & 1 & \ldots & 1 \\ z_1 & z_2 & \ldots & z_p \\ \cdot & \cdot & \ldots & \cdot \\ \cdot & \cdot & \ldots & \cdot \\ \cdot & \cdot & \ldots & \cdot \\ z_1^{N-1} & z_2^{N-1} & \ldots & z_p^{N-1} \end{bmatrix}$$

Dans un mode de réalisation préférentiel de l'invention, ledit modèle prédéterminé d'amplificateur est un modèle polynomial.

Il est clair que plus le degré du polynôme modélisant l'amplificateur est élevé, plus la précision de l'amplificateur modélisé est grande. La fonction de transfert modélisant l' amplificateur (fonction de transfert tension/tension) peut être donnée en RF par un polynôme, la détermination des coefficients complexes de ce polynôme pouvant en revanche être faite en bande de base.

Préférentiellement, ledit modèle polynomial est d'ordre impair et ne prend pas en compte les termes d'ordre pair.

Les termes d'ordre pair peuvent ne pas être pris en compte car ils ne génèrent pas d'harmoniques dans la bande du signal hautes fréquences.

De façon préférentielle, ledit modèle polynomial s'écrit, en bande de base :

$$\tilde{y} = \tilde{x} * \tilde{G}_a\text{, où :}$$

- l'entrée s'écrit : $\tilde{x} = x_i + j * x_q$
- la sortie s'écrit : $\tilde{y} = y_i + j * y_q$
- $\tilde{G}_a(P_x) = \tilde{a}_1 + (3/4).\tilde{a}_3.(P_x) + (5/8).\tilde{a}_5.(P_x)^2 + (35/64).\tilde{a}_7.(P_x)^3 + \ldots$, où :
  * $P_x = x_i^2 + x_q^2$ ;
  * $\tilde{a}_i = a_i.e^{-j\omega\tau_i}$
  * $x_i$ et $x_q$ sont les composantes en phase et en quadrature de x ;
  * $y_i$ et $y_q$ sont les composantes en phase et en quadrature de y ;
  * les coefficients $a_i$ et les retards $\tau_i$ associés sont les paramètres dudit modèle prédéterminé d'amplificateur.

Le passage en bande de base permet de faciliter le calcul des paramètres caractérisant l'amplificateur modélisé.

De façon préférentielle, ledit signal test est un signal n tons dont les fréquences et les amplitudes sont connues.

De cette façon, il est possible de déterminer a priori les fréquences auxquelles les produits d'intermodulation sont susceptibles d'apparaître dans le signal test amplifié. L'exploitation de cette information permet l'utilisation d'algorithmes d'identification du modèle d'amplificateur beaucoup plus simples et performants que ceux utilisables dans le cas général.

De manière préférentielle, le signal test est composé de deux sinusoïdes (n = 2) de même amplitude.

L'invention concerne également un système de linéarisation numérique d'un amplificateur présentant une non-linéarité, dont les moyens de détermination de paramètres de correction comprennent :

- des moyens d'acquisition dudit signal test amplifié, sous forme d'échantillons en bande de base ;
- des moyens de définition d'un amplificateur modélisé, par calcul de paramètres d'un modèle prédéterminé d'amplificateur à partir desdits échantillons du signal test amplifié ;
- des moyens de calcul desdits paramètres de correction à partir dudit amplificateur modélisé, de façon que ceux-ci permettent de linéariser ledit amplificateur modélisé.

D'autres caractéristiques et avantages de l'invention apparaîtront à la lecture de la description suivante d'un mode de réalisation préférentiel de l'invention, donné à titre de simple exemple indicatif et non limitatif, et des dessins annexés, dans lesquels :

- les figures 1 et 2 illustrent chacune un système connu de linéarisation d'un amplificateur, comprenant une boucle analogique respectivement à rétroaction ("feedback") (fig.1) ou à action directe ("feedforward") (fig.2);
- la figure 3 présente un organigramme simplifié d'un mode de réalisation particulier du procédé selon l'invention de linéarisation numérique d'un amplificateur ; et
- la figure 4 présente un schéma simplifié d'un mode de réalisation particulier du système selon l'invention de linéarisation numérique d'un amplificateur mettant en oeuvre le procédé de la figure 3.

L'invention concerne donc un procédé et un système de linéarisation numérique d'un amplificateur.

Comme présenté sur l'organigramme de la figure 3, le procédé de linéarisation de l'invention est du type comprenant deux phases 1, 2 successives.

La première phase 1 vise à déterminer des paramètres de correction de la non-linéarité de l' amplificateur. On rappelle que la correction définie par ces paramètres, destinée à être utilisée lors de la seconde phase 2 détaillée ci-dessous, est une prédistorsion présentant une non-linéarité inverse de celle de l'amplificateur. La détermination des paramètres de correction est faite en appliquant un signal test prédéterminé en entrée de l' amplificateur et en analysant le signal obtenu en sortie (appelé signal tes! amplifié). A l'issue de cette première phase 1, les paramètres de correction sont stockés, par exemple dans une table dite de prédistorsion.

La seconde phase 2 vise à amplifier de façon linéraire un signal donné. Elle comprend les deux étapes suivantes : une étape 21 de prédistorsion, en fonction des paramètres de correction préalablement déterminés, du signal

à amplifier, de façon à obtenir un signal prédistordu ; et une étape 22 d'amplification, par l'amplificateur, du signal prédistordu. Si la prédistorsion est bien adaptée, le signal présent en sortie de l'amplificateur correspond au signal d'entrée amplifié de façon linéaire.

La présente invention porte plus précisément sur une nouvelle façon de réaliser la première phase 1, de détermination des paramètres de correction de la non-linéarité de l'amplificateur.

Selon l'invention, cette première phase 1 comprend les étapes suivantes :

- acquisition (11) du signal test amplifié, sous forme d'échantillons en bande de base ;
- définition (12) d'un amplificateur modélisé, par calcul de paramètres d'un modèle prédéterminé d'amplificateur à partir des échantillons du signal test amplifié ;
- calcul (13) des paramètres de correction à partir de l'amplificateur modélisé, de façon que ceux-ci permettent de linéariser l'amplificateur modélisé.

Dans le mode de réalisation particulier décrit par la suite, l'étape 12 de définition de l'amplificateur modélisé comprend les étapes suivantes :

- estimation (121) des amplitudes complexes d'un nombre prédéterminé d'harmoniques à des fréquences connues. Ces harmoniques sont générées par le passage du signal test appliqué en entrée dans la non-linéarité de l' amplificateur. Cette estimation est effectuée par analyse spectrale des échantillons du signal test amplifié ;
- calcul (122) des paramètres du modèle prédéterminé d'amplificateur, par identification d'une part des amplitudes complexes estimées et d'autre part d'expressions mathématiques correspondant à des amplitudes complexes d'harmoniques aux fréquences connues pour un signal présent en sortie de l'amplificateur modélisé. Les expressions mathématiques sont calculées à partir du modèle prédéterminé d'amplificateur, en supposant que le signal test lui est appliqué en entrée.

On présente maintenant un mode de réalisation particulier de l'étape 11 d'acquisition du signal test amplifié (sous forme d'échantillons en bande de base).

On suppose que le signal test appliqué à l'entrée de l'amplificateur, est un signal deux tons, pouvant s'écrire :

$$e_n = A_1.e^{j(2\pi f_1 nT + \Theta_1)} + A_2.e^{j(2\pi f_2 nT + \Theta_2)}$$

Dans un souci de simplification, on choisit de prendre :

- $A_1 = A_2 = 1$ , ce qui signifie que les deux sinusoïdes ont même amplitude ;
- $\Theta_1 = \Theta_2 = 0$ , ce qui revient à prendre une bonne origine des temps.

En sortie de l'amplificateur, du fait de la non-linéarité de ce dernier, le signal de test amplifié présente différentes harmoniques. Le signal test amplifié est ramené en bande de base (ou encore à une fréquence intermédiaire suffisamment faible), puis filtré pour éliminer les harmoniques d'ordres élevés. Après filtrage, il ne reste plus que des produits d'intermodulation d'ordres impairs (ordres 3, 5, 7, 9, ...). On dispose donc d'une somme de sinusoïdes aux fréquences $f_1$, $f_2$, $2{*}f_1{-}f_2$, $2{*}f_2{-}f_1$, $3{*}f_1{-}2{*}f_2$, $3{*}f_2{-}2{*}f_1$, $4{*}f_2{-}3{*}f_1$, $4{*}f_1{-}3{*}f_2$, etc. Le signal filtré est ensuite échantillonné avant de passer dans des convertisseurs analogiques/numériques.

Au final, on dispose donc d'une représentation du signal test amplifié, sous forme d'échantillons numériques en bande de base.

On présente maintenant un mode de réalisation particulier de l'étape 121 d'estimation des amplitudes complexes de certaines d'harmoniques. Dans ce mode de réalisation particulier, on effectue une analyse spectrale paramétrique des échantillons du signal test amplifié, par exemple selon une technique dite AR ou ARMA (pour "Auto Regressive" et "Auto Regressive Moving Average" respectivement, en anglais).

On utilise en outre un modèle prédéterminé de signal, dérivé du modèle de Prony et tel que le $n^{ième}$ échantillon du signal test amplifié peut être estimé par :

$$\hat{s}_n = \sum_{i=1}^{i=p} \tilde{H_i} e^{j(2\pi f_i nT)} + e_n, \text{ où :}$$

- p est le nombre d'harmoniques considérées ;

- $f_i$ est la fréquence de la $i^{ème}$ harmonique considérée ;
- $H_i^{\sim}$ est l'amplitudes complexe de la $i^{ème}$ harmonique considérée ;
- T est la période d'échantillonnage ;
- $e_n$ est le bruit, par exemple de quantification des convertisseurs analogiques/numériques, dont est entaché l'échantillon $s_n$.

Par exemple, si l'on veut estimer les harmoniques générées jusqu'à l'ordre 5, il faut prendre : p = 6. On cherche alors les amplitudes complexes suivantes : $H_1^{\sim}$, $H_2^{\sim}$, $H_3^{\sim}$, $H_4^{\sim}$, $H_5^{\sim}$ et $H_6^{\sim}$. Les fréquences $f_i$ associées sont les suivantes : $f_1$, $f_2$, $2^*f_1-f_2$, $2^*f_2-f_1$, $3^*f_1-2^*f_2$, $3^*f_2-2^*f_1$.

Comme expliqué par la suite, les amplitudes complexes $H_i^{\sim}$ des harmoniques permettent de construire l'amplificateur modélisé (c'est-à-dire d'en déterminer les paramètres) et donc la table de prédistorsion. En effet, ces amplitudes caractérisent la distorsion AM-AM et AM-PM de l'amplificateur.

En notant $S = [s_0\, s_1 \ldots s_N]^T$, le vecteur des échantillons acquis lors de l'étape 11 d'acquisition du signal test amplifié, et $\hat{S} = [\hat{s}_0\, \hat{s}_1 \ldots \hat{s}_N]^T$, le vecteur des échantillons estimés selon le modèle de signal précité, et en minimisant (par exemple au sens des moindres carrés) la distance $\|S - \hat{S}\|$, on démontre que :

$$H^{\sim} = M\, S, \text{ avec :}$$

- $H^{\sim} = [H_1^{\sim}\, H_2^{\sim} \ldots H_p^{\sim}]^T$, le vecteur des amplitudes complexes des p harmoniques considérées ;
- $S = [s_0\, s_1 \ldots s_N]^T$, le vecteur des N échantillons du signal test amplifié pris en compte pour le calcul des amplitudes complexes d'harmoniques. Le nombre N dépend de la durée de la fenêtre d'échantillonnage et du facteur de suréchantillonnage. Par exemple, avec une fenêtre de 1 ms et un facteur de 2, on obtient: N = 36 (pour un débit symbole de 18 kHz);
- M une matrice (p,N) prédéterminée, pouvant s'écrire : $M = ([Z^H Z]^{-1} Z^H)$, avec : $z_i = \exp(2j\pi f_i)$, $Z^H$ la transposée Hermitienne de Z, et

$$Z = \begin{bmatrix} 1 & 1 & \cdots & 1 \\ z_1 & z_2 & \cdots & z_p \\ \cdot & \cdot & \cdots & \cdot \\ \cdot & \cdot & \cdots & \cdot \\ \cdot & \cdot & \cdots & \cdot \\ z_1^{N-1} & z_2^{N-1} & \cdots & z_p^{N-1} \end{bmatrix}$$

On présente ci-dessous un mode de réalisation particulier de l'étape 122 de calcul des paramètres du modèle prédéterminé d'amplificateur.

Le modèle prédéterminé d'amplificateur est par exemple un modèle polynomial d'ordre impair (5, 7, voire 9 suivant le degré de précision souhaité), qui s'écrit sous la forme suivante (en allant par exemple jusqu'à l'ordre 7) :

$$y(t) = a_1{}^*x(t-\tau_1) + a_3{}^*x(t-\tau_3)^3 + a_5{}^*x(t-\tau_5)^5 + a_7{}^*x(t-\tau_7)^7 \qquad (1)$$

x(t) et y(t) sont les signaux d'entrée et de sortie respectivement. Les coefficients $a_i$ et les retards $\tau_i$ sont les paramètres du modèle prédéterminé d'amplificateur. Ce modèle ne tient donc pas compte des termes d'ordre pair car ces derniers ne génèrent aucune harmonique dans la bande du signal RF (Radio Fréquence).

Le signal modulé x(t) peut s'écrire, en fonction de ses composantes en phase $x_i$ et en quadrature $x_q$, et avec $\omega = 2\pi ft$, f étant la fréquence de la porteuse :

$$x(t) = x_i{}^* \cos(\omega t) - x_q{}^* \sin(\omega t) \qquad (2)$$

De même, le signal y(t) en sortie de l'amplificateur peut s'écrire, en fonction de ses composantes en phase $y_i$ et en quadrature $y_q$ :

$$y(t) = y_i * \cos(\omega t) - y_q * \sin(\omega t) \quad (3)$$

En remplaçant dans (1), x(t) par son expression obtenue en (2), on obtient après calculs :

$$y(t) = x_i * Re[e^{j\omega t} * G_a^{\sim}] - x_q * Im[e^{j\omega t} * G_a^{\sim}] \quad (4)$$

avec :

$$G^{\sim}_a = a_1.e^{-j\omega\tau_1} + (3/4).a_3.e^{-j\omega\tau_3}.(x_i^2 + x_q^2) + (5/8).a_5.e^{-j\omega\tau_5}.(x_i^2 + x_q^2)^2 + (35/64).a_7.e^{-j\omega\tau_7}.(x_i^2 + x_q^2)^3 \quad (5)$$

soit :

$$G^{\sim}_a = a_1^{\sim} + (3/4).a_3^{\sim}*(P_x) + (5/8).a_5^{\sim}*(P_x)^2 + (35/64).a_7^{\sim}*(P_x)^3 \quad (5)$$

en posant :

$$a_i^{\sim} = a_i.e^{-j\omega\tau_i}$$

et : $P_x = x^2_I + x^2_q$

En combinant (3) et (4), et en posant: $G^{\sim}_a = G_{a_i} + j * G_{a_q}$, on obtient :

$$y_i = x_i * G_{a_i} - x_q * G_{a_q} \text{ et } y_q = x_i * G_{a_q} + x_q * G_{a_i}$$

ce qui peut aussi s'écrire :

$$y^{\sim} = x^{\sim} * G^{\sim}_a \quad (6)$$

avec : $x^{\sim} = x_i + j * x_q$ et $y^{\sim} = y_i + j * y_q$

Ceci est la représentation en bande de base de la modélisation polynomiale (1) en RF de l'amplificateur. On peut noter que les distorsions de phase et d'amplitudes de l'amplificateur ne dépendent que de la puissance instantanée $P_x$ du signal d'entrée. Ce fait est utilisé pour la construction de la table de prédistorsion, comme expliqué par la suite.

Pour plus de clarté, nous remplacerons, si besoin est, $G^{\sim}_a = G_{a_i} + j * G_{a_q}$ par $G^{\sim}_a(P_x) = G_{a_i}(P_x) + j * G_{a_q}(P_x)$

Les distorsions d'amplitude et de phase de l'amplificateur s'écrivent en bande de base :

- distorsion d'amplitude (AM-AM) : $p_y = p_x * |G^{\sim}_a(P_x)|^2$ ;
- distorsion de phase (AM-PM) : $\arg(y^{\sim}) = \arg(x^{\sim}) + \arg(G^{\sim}_a(P_x))$

Pour "construire" l'amplificateur modélisé, il faut déterminer la valeur des paramètres ai et $\tau_i$. Pour cela, comme expliqué précédemment, on fait passer au travers de l'amplificateur non-linéaire un signal test qui est un signal deux tons. On a donc :

$$x_{test}(t) = A_1 \cos(\omega_1 t + \Theta_1) + A_2 \cos(\omega_2 t + \Theta_2) \quad (7)$$

Pour la simplicité du modèle, on prend : $A_1 = A_2 = 1$ et $\Theta_1 = \Theta_2 = 0$, comme indiqué ci-dessus.

En remplaçant, dans l'expression (1), x(t) par $x_{test}(t)$ selon l'expression (7), et:

- en tenant compte du fait que : $\omega_1 * \tau_i \approx \omega_2 * \tau_i \approx \omega * \tau_i$ ;
- en supposant que : $\omega_1 = \omega - \Delta\omega$ et $\omega_2 = \omega + \Delta\omega$, où $\Delta\omega << \omega$;
- en notant que pour les amplificateurs classiques, les $\tau_k$ sont de l'ordre de la nanoseconde et l'on choisit dans la mesure du possible $\Delta\omega$ tel que $\Delta\omega.\tau k << 1$ ;
- en éliminant les harmoniques qui ne sont pas dans la bande utile ; on obtient après calculs :

$$y(t)_{filtré} = Re[H_1{}^{\sim} * (e^{j\omega_1 t} + e^{j\omega_2 t})] + Re[H_3{}^{\sim} * (e^{j(2\omega_2 - \omega_1)t} + e^{j(2\omega_1 - \omega_2)t})] + Re[H_5{}^{\sim} * (e^{j(3\omega_2 - 2\omega_1)t} + e^{j(3\omega_1 - 2\omega_2)t})] + Re[H_7{}^{\sim} * (e^{j(4\omega_2 - 3\omega_1)t} + e^{j(4\omega_1 - 3\omega_2)t})] \quad (8)$$

avec :

$$H_1{}^{\sim} = a_1{}^{\sim} + (9/4)\, a_3{}^{\sim} + (25/4)\, a_5{}^{\sim} + (1225/64)\, a_7{}^{\sim} \quad (9)$$

$$H_3{}^{\sim} = (3/4)\, a_3{}^{\sim} + (25/8)\, a_5{}^{\sim} + (735/64)\, a_7{}^{\sim} \quad (10)$$

$$H_5{}^{\sim} = (5/8)\, a_5{}^{\sim} + (245/64)\, a_7{}^{\sim} \quad (11)$$

$$H_7{}^{\sim} = (35/64)\, a_7{}^{\sim} \quad (12)$$

Les amplitudes complexes $H_i$~ ont été estimées précédemment, lors de l'étape 121. Il est donc possible, en inversant le système formé par les équations (9) à (12), de retrouver les coefficients ai et $\tau_i$, c'est-à-dire les paramètres de l'amplificateur modélisé. On obtient :

$$a_1{}^{\sim} = (H_1{}^{\sim} - 3 * H_3{}^{\sim} + 5 * H_5{}^{\sim} - 7 * H_7{}^{\sim}) \quad (13)$$

$$a_3{}^{\sim} = (4/3)\,(H_3{}^{\sim} - 5 * H_5{}^{\sim} + 14 * H_7{}^{\sim}) \quad (14)$$

$$a_5{}^{\sim} = (8/5)\,(H_5{}^{\sim} - 7 * H_7{}^{\sim}) \quad (15)$$

$$a_7{}^{\sim} = (64/35)\,(H_7{}^{\sim}) \quad (16)$$

Ainsi, l'amplificateur modélisé est parfaitement défini en bande de base. Il va maintenant être utilisé pour construire la table de prédistorsion.

On présente maintenant un mode de réalisation particulier de l'étape 13 de calcul des paramètres de correction.

Le signal $y^{\sim}{}_{_linéaire}$, que l'on souhaite avoir en sortie et que l'on obtiendrait si l'amplificateur était linéaire, peut s'écrire :

$$y^{\sim}{}_{_linéaire} = K * x^{\sim} \quad (17)$$

où K est le gain idéal de l'amplificateur et x~ le signal modulé en bande de base à l'entrée de l'amplificateur.

Il est à noter que le gain K de l'amplificateur est constant : il ne dépend pas onc de la puissance instantanée du signal x~ à l'entrée de l'amplificateur. Par souci de simplification, le gain K est supposé réel (pas de déphasage entre l'entrée et la sortie de l'amplificateur que l'on désire linéariser).

On cherche un signal, $z^{\sim} = z_i + j * z_q$, à appliquer à la place de x~ à l'entrée de l'amplificateur non-linéaire, et permettant d'obtenir en sortie $y^{\sim}{}_{_linéaire}$. En d'autres termes, on cherche le signal z~, correspondant au signal x~ prédistordu, tel que :

$$z^{\sim} * G^{\sim}{}_a(P_z) = y^{\sim}{}_{_linéaire} = K * x^{\sim} \quad (18)$$

où $P_z = z^2{}_i + z^2{}_q$.

Il n'est pas possible d'inverser la relation (18) directement, c'est-à-dire de calculer z~ à partir de x~. Cependant, on déduit aisément de (18) que :

- si $P_z$ est connu, alors z~ est entièrement déterminé. En effet, on a : $z^{\sim} = (K/G^{\sim}{}_a(P_z)) * x^{\sim}$ (19)
- le choix de $P_z$ ne dépend que de $P_x$. En effet, d'après (18), on a :

$$P_z * |G^{\sim}{}_a(P_z)|^2 = K^2 * P_x \quad (20)$$

Cette relation est la seule condition sur $P_z$.

Pour calculer z~ à partir de x~, on procède alors de la façon suivante :

- on calcule la puissance instantanée $P_x$ du signal x~: $P_x = x_i^2 + x_q^2$ ;
- on détermine $P_z$ vérifiant (20);
- on calcule alors z~ grâce à (19) :

$$z^{\sim} = G^{\sim}{}_p(P_x) * x^{\sim} \quad (21)$$

avec :

$$G^{\sim}{}_p(P_x) = K / G^{\sim}{}_a(P_z) \quad (22)$$

Le contenu d'une table de prédistorsion, comportant les paramètres de correction, découle narurellement de ce qui précède. Cette table a pour entrée $P_x$ et fournit en sortie la valeur $G^{\sim}{}_p(P_x)$, qui apparaît comme un "gain complexe de prédistorsion" d'après (21). La valeur du signal prédistordu est obtenu en appliquant ce gain complexe $G^{\sim}{}_p(P_x)$ à x~.

L'invention concerne également un système de linéarisation numérique d'un amplificateur. On en présente maintenant, en relation avec la figure 4, un mode de réalisation particulier.

Ce système comprend :

- un convertisseur numérique/analogique 41, recevant soit un signal prédistordu 47 soit un signal test 49, selon le mode de fonctionnement du système (comme expliqué ci-dessous);
- des moyens 42 de mise sur porteuse, sur deux voies I et Q en quadrature, placés en aval du convertisseur numérique/analogique 41;
- un amplificateur 43, placé en aval des moyens 42 de mise sur porteuse et délivrant un signal amplifié 44. On rappelle que cet amplificateur 43 présente une non-linéarité que l'on souhaite compenser par une prédistorsion;
- des moyens 45 de prédistorsion, recevant un signal numérique à amplifier 46 et délivrant un signal prédistordu 47 (à destination du convertisseur numérique/analogique 41);
- des moyens 48 de génération d'un signal test 49, à destination du convertisseur numérique/analogique 41;
- des moyens 50 de détermination des paramètres de correction utilisés par les moyens 45 de prédistorsion;
- des premiers moyens 51 de commutation, permettant d'appliquer en entrée du convertisseur numérique/analogique 41, soit le signal prédistordu 47 soit le signal test 49;
- des seconds moyens 52 (optionnels) de commutation, permettant de diriger le signal amplifié 44 soit vers la sortie du système (correspondant par exemple à une antenne 54), soit vers les moyens 50 de détermination des paramètres de correction;
- des troisièmes moyens 53 de commutation, permettant de relier ou non les moyens 45 de prédistorsion aux moyens 50 de détermination des paramètres de correction.

Le système présente deux modes de fonctionnement, correspondant aux deux phases 1, 2 du procédé décrit ci-dessus en relation avec la figure 3, à savoir :

- un mode "acquisition", dans lequel le convertisseur numérique/analogique 41 reçoit le test 49, et les moyens 50 de détermination des paramètres de correction reçoivent le signal amplifié 44 (qui est alors le signal test amplifié 55) et sont reliés aux moyens 45 de prédistorsion (à qui ils communiquent les nouveaux paramètres de correction);
- un mode "amplification", dans lequel le convertisseur numérique/analogique 41 reçoit le signal prédistordu 47, et le signal amplifié 44 est transmis à l'antenne 54.

Dans un mode particulier de l'invention, les moyens 50 de détermination des paramètres de correction comprennent :

- des moyens 56 de démodulation du signal test amplifié 55;
- un convertisseur analogique/numérique 57, placé en aval des moyens 56 de démodulation;
- des moyens 58 de définition d'un amplificateur modélisé;
- des moyens 59 de calcul, à partir de l'amplificateur modélisé, des paramètres de correction. En d'autres termes, ce sont des moyens de construction de la table de prédistorsion utilisée par les moyens 45 de prédistorsion en mode d'amplification.

Les moyens 58 de définition et 59 de calcul sont par exemple compris dans un processeur de signaux numériques (DSP) 60. Leur fonctionnement, ainsi que celui des moyens 45 de prédistorsion, correspond à la mise en oeuvre des étape a du même nom, telles que décrites ci-dessus, en relation avec la figure 3. Ce fonctionnement n'est donc pas décrit à nouveau.

## Revendications

1. Procédé de linéarisation numérique d'un amplificateur présentant une non-linéarité, du type comprenant :

    - une phase préalable (1) de détermination de paramètres de correction de ladite non-linéarité, en fonction d'un signal test amplifié présent en sortie dudit amplificateur lorsqu'un signal test est appliqué en entrée;
    - une phase (2) d'amplification linéaire, comprenant les étapes suivantes :

        * prédistorsion (21), en fonction desdits paramètres de correction, d'un signal d'entrée destiné à être amplifié par ledit amplificateur, de façon à obtenir un signal prédistordu;
        * amplification (22) dudit signal prédistordu par ledit amplificateur, de façon que le signal prédistordu amplifié présent en sortie dudit amplificateur corresponde audit signal d'entrée amplifié de façon linéaire;

    caractérisé en ce que ladite phase (1) de détermination des paramètres de correction comprend les étapes suivantes :
    - acquisition (11) dudit signal test amplifié, sous forme d'échantillons en bande de base;
    - définition (12) d'un amplificateur modélisé, par calcul de paramètres d'un modèle prédéterminé d'amplificateur à partir desdits échantillons du signal test amplifié;
    - calcul (13) desdits paramètres de correction à partir dudit amplificateur modélisé, de façon que ceux-ci permettent de linéariser ledit amplificateur modélisé.

2. Procédé selon la revendication 1, caractérisé en ce que ladite étape (12) de définition de l'amplificateur modélisé comprend les étapes suivantes :

    - estimation (121), par analyse spectrale desdits échantillons du signal test amplifié, des amplitudes complexes d'un nombre prédéterminé d'harmoniques à des fréquences connues, lesdites harmoniques étant générées par ladite non-linéarité de l'amplificateur;
    - calcul (122) desdits paramètres du modèle prédéterminé d'amplificateur, par identification d'une part desdites amplitudes complexes estimées et d'autre part d'expressions mathématiques correspondant à des amplitudes complexes d'harmoniques auxdites fréquences connues pour un signal présent en sortie dudit amplificateur modélisé, lesdites expressions mathématiques étant calculées à partir dudit modèle prédéterminé d'amplificateur en supposant que ledit signal test lui est appliqué en entrée.

3. Procédé selon la revendication 2, caractérisé en ce que ladite analyse spectrale des échantillons du signal test amplifié appartient au groupe comprenant :

    - les analyses spectrales paramétriques;
    - les analyses spectrales par échantillonnage suivi d'une transformée de Fourier.

4. Procédé selon la revendication 3, caractérisé en ce que ladite étape (121) d'estimation des amplitudes complexes d'harmoniques consiste à calculer : $H^{\sim} = M\,S$, avec :

    - $H^{\sim} = [H_1^{\sim}\ H_2^{\sim}\ ...\ H_p^{\sim}]^T$, un vecteur des amplitudes complexes de p harmoniques considérées;
    - $S = [s_0\ s_1\ ...\ S_N]T$, un vecteur de N échantillons du signal test amplifié ;
    - M étant une matrice (p,N) prédéterminée.

5. Procédé selon la revendication 4, caractérisé en ce que ladite matrice M s'écrit : $M = ([Z^H Z]^{-1} Z^H)$, avec :

    - $Z^H$ la transposée Hermitienne de Z;
    - $z_i = \exp(2j\pi f_i)$, $f_i$ étant la fréquence de la ième harmonique considérée;
    -

$$Z = \begin{bmatrix} 1 & 1 & \cdots & 1 \\ Z_1 & Z_2 & \cdots & Z_P \\ \cdot & \cdot & \cdots & \cdot \\ \cdot & \cdot & \cdots & \cdot \\ \cdot & \cdot & \cdots & \cdot \\ Z_1^{N-1} & Z_2^{N-1} & \cdots & Z_P^{N-1} \end{bmatrix}$$

**6.** Procédé selon l'une quelconque des revendications 1 à 5, caractérisé en ce que ledit modèle prédéterminé d'amplificateur est un modèle polynomial.

**7.** Procédé selon la revendication 6, caractérisé en ce que ledit modèle polynomial est d'ordre impair et ne prend pas en compte les termes d'ordre pair.

**8.** Procédé selon la revendication 7, caractérisé en ce que ledit modèle polynomial s'écrit, en bande de base : $y^{\sim} = x^{\sim} * G^{\sim}{}_a$, où :

- l'entrée s'écrit: $x^{\sim} = x_i + j * x_q$
- la sortie s'écrit : $y^{\sim} = y_i + j * y_q$
- $G^{\sim}{}_a(P_x) = a_1{}^{\sim} + (3/4).a_3{}^{\sim}.(P_x) + (5/8).a_5{}^{\sim}.(P_x)^2 + (35/64).a_7{}^{\sim}.(Px)^3 + \ldots$, où :
  * $P_x = x_i{}^2 + x_q{}^2$ ;
  * $a_i{}^{\sim} = a_i.e^{-j\omega\tau_i}$
  * $x_i$ et $x_q$ sont les composantes en phase et en quadrature de x;
  * $y_i$ et $y_q$ sont les composantes en phase et en quadrature de y;
  * les coefficients $a_i$ et les retards $\tau_i$ associés sont les paramètres dudit modèle prédéterminé d'amplificateur.

**9.** Procédé selon l'une quelconque des revendications 1 à 8, caractérisé en ce que ledit signal test est un signal n tons dont les fréquences et les amplitudes sont connues.

**10.** Système de linéarisation numérique d'un amplificateur présentant une non-linéarité, du type comprenant :

- des moyens (50) de détermination de paramètres de correction de ladite non-linéarité, en fonction d'un signal test amplifié (55) présent en sortie dudit amplificateur (43) lorsqu'un signal test (49) est appliqué en entrée ;
- des moyens d'amplification linéaire, comprenant :
  * des moyens (45) de prédistorsion, en fonction desdits paramètres de correction, d'un signal d'entrée destiné à être amplifié par ledit amplificateur, de façon à obtenir un signal prédistordu;
  * ledit amplificateur (43), permettant d'amplifier ledit signal prédistordu, de façon que le signal prédistordu amplifié présent en sortie dudit amplificateur corresponde audit signal d'entrée amplifié de façon linéaire;

caractérisé en ce que lesdits moyens (50) de détermination de paramètres de correction comprennent :

- des moyens (56, 57) d'acquisition dudit signal test amplifié, sous forme d'échantillons en bande de base ;
- des moyens (58) de définition d'un amplificateur modélisé, par calcul de paramètres d'un modèle prédéterminé d'amplificateur à partir desdits échantillons du signal test amplifié ;

- des moyens (59) de calcul desdits paramètres de correction à partir dudit amplificateur modélisé, de façon que ceux-ci permettent de linéariser ledit amplificateur modélisé.

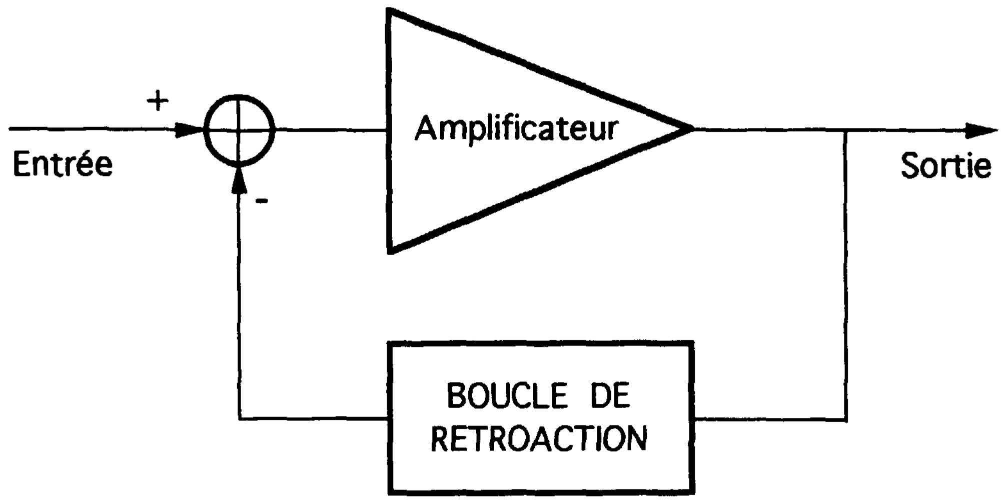
+
Entrée
-
Amplificateur
Sortie
BOUCLE DE
RETROACTION

Fig. 1

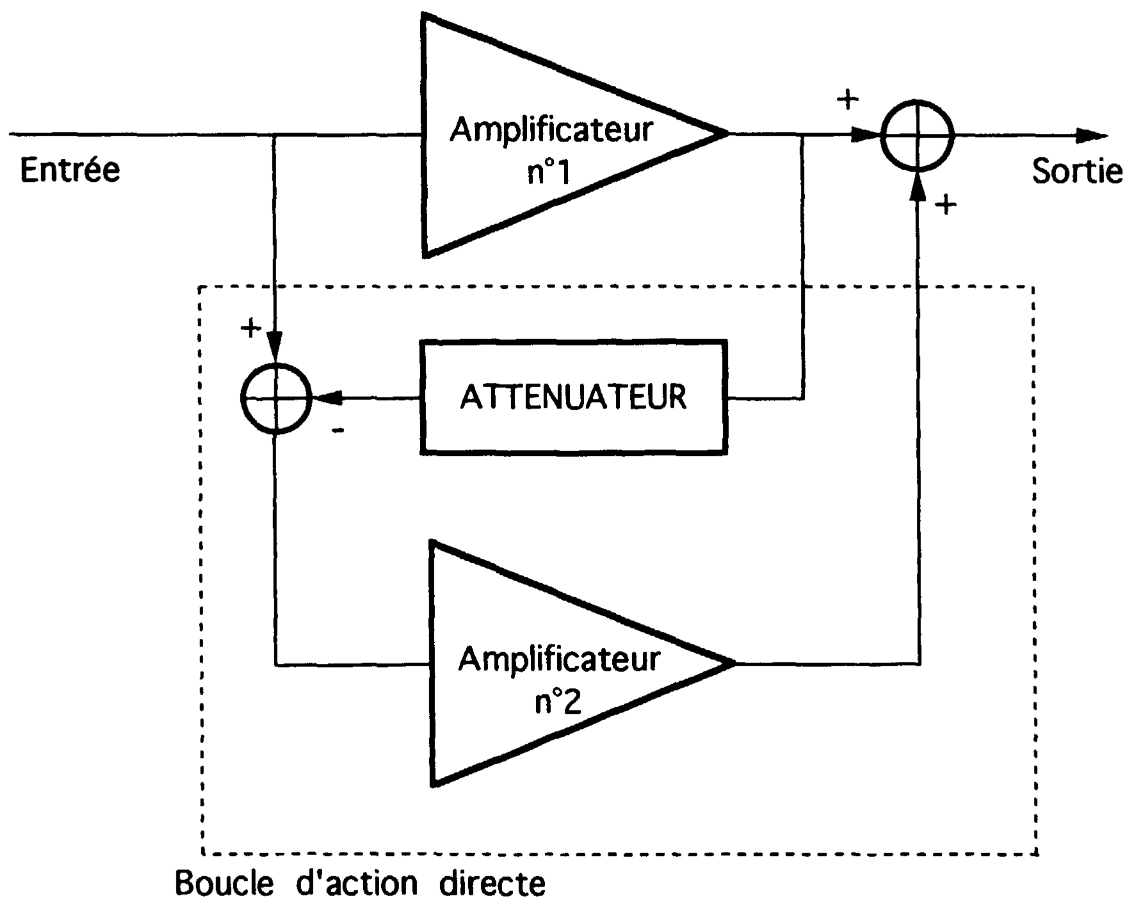
Entrée
Amplificateur
n°1
+
+
Sortie
+
ATTENUATEUR
-
Amplificateur
n°2
Boucle d'action directe

Fig. 2

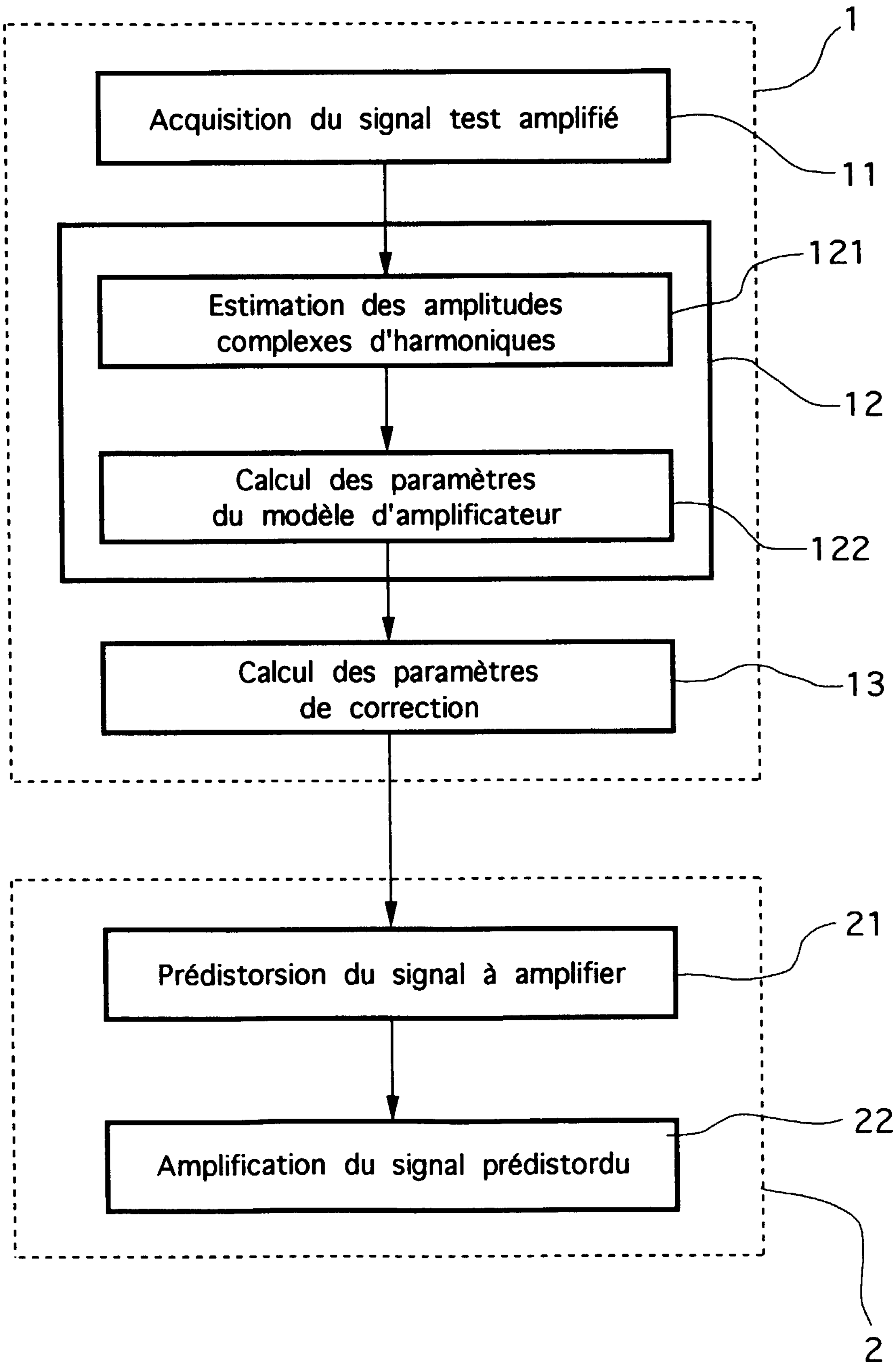
Acquisition du signal test amplifié
Estimation des amplitudes complexes d'harmoniques
Calcul des paramètres du modèle d'amplificateur
Calcul des paramètres de correction
Prédistorsion du signal à amplifier
Amplification du signal prédistordu
1
11
121
12
122
13
21
22
2

Fig. 3

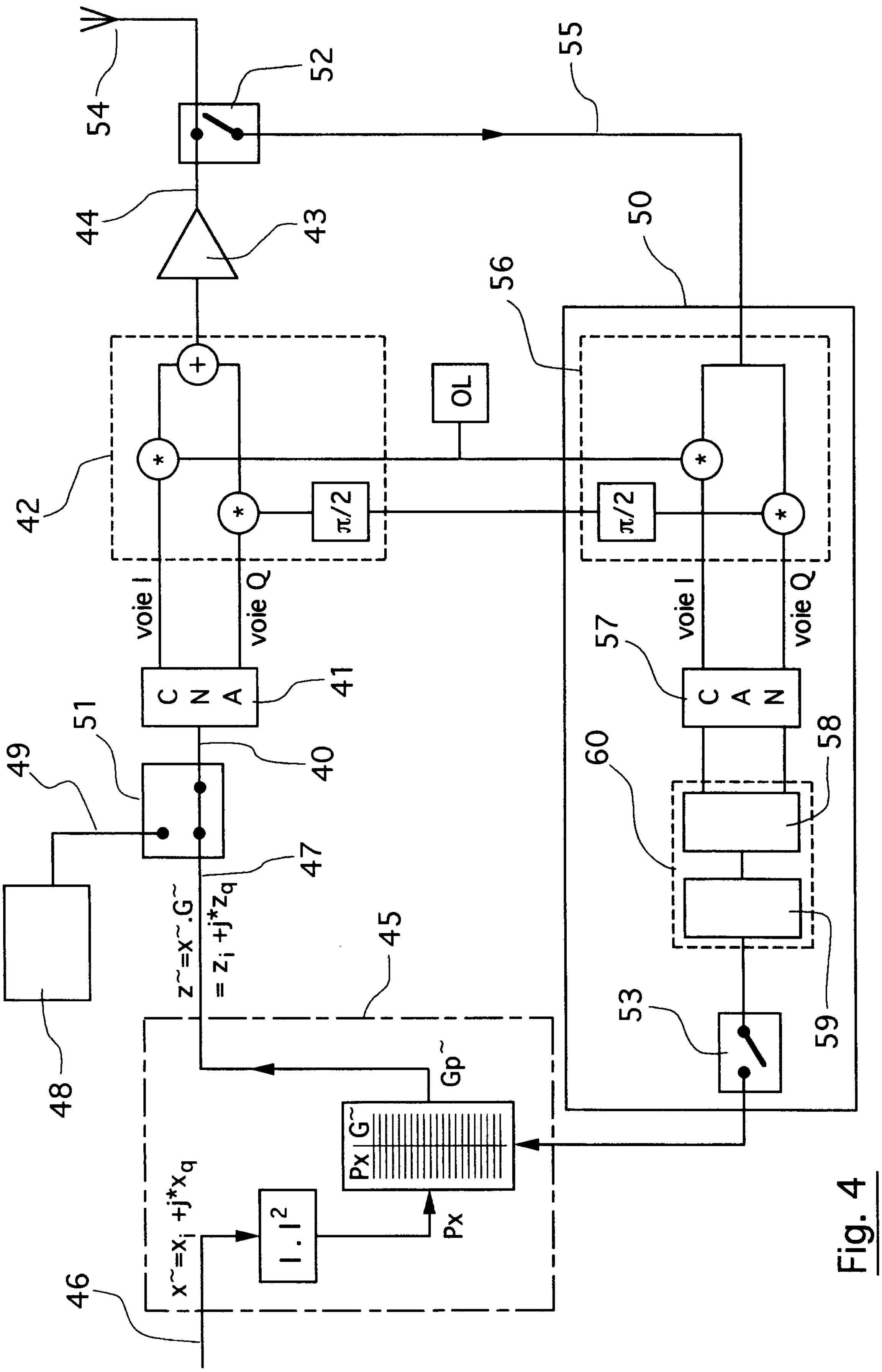
54
52
55
44
43
50
56
42
OL
+
*
π/2
voie I
voie Q
C N A
C A N
41
57
51
49
40
58
60
47
z~=x~.G~
= z_i +j*z_q
45
53
59
48
Gp~
Px
G~
|.|²
x~=x_i +j*x_q
46

Fig. 4

Office européen des brevets

# RAPPORT DE RECHERCHE EUROPEENNE

Numéro de la demande
EP 98 40 3344

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X<br>Y | US 5 148 448 A (KARAM GEORGES ET AL) 15 septembre 1992<br>* le document en entier * | 1-3,10<br>4-9 | H03F1/32 |
| X | US 5 113 414 A (KARAM GEORGES ET AL) 12 mai 1992<br>* le document en entier * | 1-3,10 | |
| Y | KARAM G ET AL: "GENERALIZED DATA PREDISTORTION USING INTERSYMBOL INTERPOLATION"<br>PHILIPS JOURNAL OF RESEARCH, vol. 46, no. 1, 1 janvier 1991, pages 1-21, XP000273934<br>* le document en entier * | 4-9 | |
| A | KARAM G ET AL: "DATA PREDISTORTION TECHNIQUES USING INTERSYMBOL INTERPOLATION"<br>IEEE TRANSACTIONS ON COMMUNICATIONS, vol. 38, no. 10, 1 octobre 1990, pages 1716-1723, XP000176868<br>* le document en entier * | 4-9 | **DOMAINES TECHNIQUES RECHERCHES (Int.Cl.6)**<br>H03F |
| A | US 4 967 164 A (SARI HIKMET) 30 octobre 1990<br>* le document en entier * | 1-10 | |
| A | US 4 291 277 A (DAVIS ROBERT C ET AL) 22 septembre 1981 | | |
| A | GB 2 283 629 A (MOTOROLA LTD) 10 mai 1995 | | |
| A | US 4 700 151 A (NAGATA YOSHINORI) 13 octobre 1987 | | |
| A | US 5 574 992 A (CYGAN LAWRENCE F ET AL) 12 novembre 1996 | | |

Le présent rapport a été établi pour toutes les revendications

| Lieu de la recherche | Date d'achèvement de la recherche | Examinateur |
|---|---|---|
| LA HAYE | 25 mars 1999 | Segaert, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)